# EUROPÄISCHE PATENTSCHRIFT

(11) **EP 4 367 772 B1**
(45) Veröffentlichungstag und Bekanntmachung des Hinweises auf die Patenterteilung: **21.10.2026**
(21) Anmeldenummer: 22761996.2
(22) Anmeldetag: 04.08.2022
(51) Int. Cl.: H02J 3/40, H02M 1/00

(54) **VERFAHREN UND VORRICHTUNG ZUM KALIBRIEREN EINES ZEITBASISSIGNALS BEI EINEM PHOTOVOLTAIK-WECHSELRICHTER**
METHOD AND DEVICE FOR CALIBRATING A TIME BASE SIGNAL IN A PHOTOVOLTAIC INVERTER
PROCÉDÉ ET DISPOSITIF D'ÉTALONNAGE D'UN SIGNAL TEMPOREL DANS UN ONDULEUR PHOTOVOLTAÏQUE

(30) Priorität: 05.08.2021 EP 21189920
(43) Veröffentlichungstag der Anmeldung: 15.05.2024
(73) Patentinhaber: FRONIUS INTERNATIONAL GmbH, 4643 Pettenbach (AT)
(72) Erfinder: PIELER, Roland, 4643 Pettenbach (AT); KREUZER, Harald, 4643 Pettenbach (AT); ANGERER, Christian, 4643 Pettenbach (AT)
(74) Vertreter: Bratovic, Nino Maria
(86) Internationale Anmeldenummer: PCT/EP2022/071989
(87) Internationale Veröffentlichungsnummer: WO 2023/012291

(56) Entgegenhaltungen:
- US-A1- 2010 254 225
- US-A1- 2020 363 832

## Beschreibung

Die Erfindung betrifft ein Verfahren und eine Vorrichtung zur Kalibrierung eines Zeitbasissignals bei einem Photovoltaik-Wechselrichter bzw. Solarwechselrichter, der einen DC-Gleichstrom in einen AC-Wechselstrom umwandelt.

Ein Photovoltaik-Wechselrichter wandelt einen lokal erzeugten Gleichstrom in einen oder mehrere Wechselströme um, welche in ein Stromversorgungsnetzwerk eingespeist werden können. Der Wechselrichter bildet dabei einen Teil einer Photovoltaik-Anlage. Solarmodule bzw. Photovoltaik-Module der Photovoltaik-Anlage erzeugen bei Sonneneinstrahlung einen Gleichstrom, der durch eine elektronische Schaltung des Photovoltaik-Wechselrichters in einen Wechselstrom umgewandelt wird. Der Photovoltaik-Wechselrichter weist eine Umwandlungsschaltung auf, die meist dreistufig ausgebildet ist. Die Umwandlungsschaltung umfasst eingangsseitig einen Gleichstrom -bzw. Gleichspannungswandler, der über einen Zwischenkreis mit einer DC-AC-Umwandlungsstufe verbunden ist. Der Gleichspannungswandler bzw. DC-DC-Wandler kann einen sogenannten Maximum Power Point Tracker aufweisen. Man unterscheidet verschiedene Typen von Solarwechselrichter, insbesondere Modulwechselrichter, Strangwechselrichter, Multistrangwechselrichter, Zentralwechselrichter sowie Hybridwechselrichter. Photovoltaik-Wechselrichter werden üblicherweise über einen längeren Zeitraum in einer Photovoltaik-Anlage installiert und werden in vielen Fällen über Jahre betrieben. Herkömmlicherweise werden Photovoltaik-Wechselrichter bei oder vor der Auslieferung an den Kunden auf ihre zuverlässige Funktionsweise und Genauigkeit durch den Hersteller überprüft. Allerdings unterliegen die elektronischen Bauteile, welche innerhalb des Photovoltaik-Wechselrichters verbaut sind, einem Alterungsprozess. Zur Generierung von Steuersignalen sowie zur Vornahme von Messungen, insbesondere Messungen der Netzfrequenz des Stromversorgungsnetzwerkes, enthalten herkömmliche Photovoltaik-Wechselrichter Zeitsignalgeber bzw. Zeitsignalgeneratoren. Der Zeitsignalgenerator erzeugt dabei ein Zeitbasissignal, auf dessen Grundlage Steuersignale zur Ansteuerung elektronischer Komponenten sowie zur Vornahme von Messungen abgeleitet werden. Durch die Alterung der zeitgebenden Bauteile innerhalb des Photovoltaik-Wechselrichters leidet auch die Mess- bzw. Frequenzmessgenauigkeit, d.h. die Frequenzgenauigkeit des Zeitbasissignales, im Laufe des Betriebes des Photovoltaik-Wechselrichters. Bei herkömmlichen Photovoltaik-Wechselrichtern werden Netzfrequenzen mit einer Auflösung im Millihertzbereich ermittelt. Die in den Photovoltaik-Wechselrichter verbauten Zeitsignalgeber weisen dabei üblicherweise schon von Beginn an, d.h. bei Auslieferung, Toleranzen in dieser Größenordnung auf. Dies kann dazu führen, dass eine Messeinheit des Photovoltaik-Wechselrichters die Netzfrequenz des Stromversorgungsnetzes nur ungenau misst und die Einspeisung des Wechselstromes entweder zu früh oder zu spät abschaltet. Eine zu frühe Abschaltung des Wechselstromes durch den Wechselrichter stellt für den Betreiber der Photovoltaik-Anlage einen Nachteil dar, da es zu einer Verminderung des eingespeisten Wechselstromes kommt. Umgekehrt führt ein verzögertes Abschalten des Photovoltaik-Wechselrichters dazu, dass er nicht den gebührenden Anteil an der Netzstabilität des Stromversorgungsnetzwerkes leisten kann. Dokument US 2010/254225 A1 offenbart bereits ein Verfahren, ein lokal generiertes Zeitbasissignal mit einem externen Referenzsignal zu korrigieren.

Es ist daher eine Aufgabe der vorliegenden Erfindung, ein Verfahren und eine Vorrichtung zu schaffen, das die oben genannten Nachteile aufgrund der Alterung von zeitgebenden Bauteilen innerhalb des Wechselrichters berücksichtigt und ausgleicht.

Diese Aufgabe wird erfindungsgemäß durch ein Verfahren mit den in Patentanspruch 1 angegebenen Merkmalen gelöst.

Die Erfindung schafft demnach ein Verfahren zum Kalibrieren eines Zeitbasissignales bei einem Photovoltaik-Wechselrichter, welcher eine Umwandlungsschaltung mit Komponenten zur Umwandlung eines DC-Gleichstroms in einen AC-Wechselstrom aufweist, mit den folgenden Schritten:
- Empfangen eines Referenzsignales durch eine Empfangseinheit des Photovoltaik-Wechselrichters von einer externen Referenzsignalquelle;
- Ermitteln einer Abweichung zwischen dem empfangenen Referenzsignal und einem Zeitbasissignal, das durch einen lokalen Zeitsignalgenerator des Photovoltaik-Wechselrichters erzeugt wird, wobei das Zeitbasissignal durch ein Taktsignal gebildet wird;
- Korrigieren des Zeitbasissignals zur Minimierung der Abweichung oder Berechnen eines Korrekturfaktors,
   wobei das von dem Zeitsignalgenerator (3) erzeugte Zeitbasissignal (ZBS) bei verfügbarem Referenzsignal (RS) in Abhängigkeit von dem Referenzsignal (RS) automatisch korrigiert wird, und
   wobei das von dem Zeitsignalgenerator erzeugte Zeitbasissignal bei temporär nicht verfügbarem Referenzsignal in Abhängigkeit von mindestens einem gespeicherten Betriebsparameter automatisch korrigiert wird, welcher durch eine innerhalb des Gehäuses des Photovoltaik-Wechselrichters herrschende gemessene Innentemperatur und/oder durch eine gemessene Versorgungsspannung gebildet wird; und
- Anpassen von Vorgabewerten für zumindest eine Komponente der Umwandlungsschaltung in Abhängigkeit des korrigierten Zeitbasissignales oder in Abhängigkeit des berechneten Korrekturfaktors.

Bei einer möglichen Ausführungsform des erfindungsgemäßen Verfahrens wird das Zeitbasissignal zur Minimierung der ermittelten Abweichung automatisch fortlaufend oder in regelmäßigen Zeitabständen korrigiert.

Bei einer möglichen Ausführungsform des erfindungsgemäßen Verfahrens werden die ermittelten Abweichungen zwischen dem von der Empfangseinheit empfangenen Referenzsignal und dem von dem Zeitsignalgenerator erzeugten Zeitbasissignal
und/oder der berechnete Korrekturfaktor zusammen mit mindestens einem Betriebsparameter des Photovoltaik-Wechselrichters in einen Datenspeicher einer Kalibriereinheit des Photovoltaik-Wechselrichters gespeichert werden.

Die Erfindung schafft ferner gemäß einem weiteren Aspekt einen Photovoltaik-Wechselrichter mit den in Patentanspruch 5 angegebenen Merkmalen.

Die Erfindung schafft demnach einen Photovoltaik-Wechselrichter mit:
- einer Umwandlungsschaltung, welche elektronische Komponenten aufweist, die einen erhaltenen DC-Gleichstrom in einen AC-Wechselstrom umwandeln;
- einem Zeitsignalgenerator, der ein Zeitbasissignal erzeugt, das ein Taktsignal aufweist;
- einer Empfangseinheit, die zum Empfang eines Referenzsignales von einer externen Referenzsignalquelle vorgesehen ist;
- einer Kalibriereinheit, welche das Zeitbasissignal von dem Zeitsignalgenerator erhält und das Zeitbasissignal auf Grundlage des von der Empfangseinheit empfangenen Referenzsignales automatisch korrigiert oder einen Korrekturfaktor berechnet,
   wobei die Kalibriereinheit dazu eingerichtet ist, das von dem Zeitsignalgenerator erzeugte Zeitbasissignal: bei verfügbarem Referenzsignal in Abhängigkeit von dem Referenzsignal automatisch zu korrigieren, und bei temporär nicht verfügbarem Referenzsignal in Abhängigkeit von mindestens einem in einem Datenspeicher des Photovoltaik-Wechselrichters gespeicherten Betriebsparameter automatisch zu korrigieren, welcher durch eine innerhalb des Gehäuses des Photovoltaik-Wechselrichters herrschende gemessene Innentemperatur und/oder durch eine gemessene Versorgungsspannung gebildet wird; und mit
- einer Steuereinheit, die einen oder mehrere Vorgabewerte für eine Regelungseinheit der Umwandlungsschaltung des Photovoltaik-Wechselrichters in Abhängigkeit des korrigierten Zeitbasissignales oder des berechneten Korrekturfaktors anpasst.

Bei einer möglichen Ausführungsform des erfindungsgemäßen Photovoltaik-Wechselrichters ermittelt die Kalibriereinheit des Photovoltaik-Wechselrichters eine Abweichung zwischen dem durch die Empfangseinheit empfangenen Referenzsignal und dem von dem Zeitsignalgenerator erhaltenen Zeitbasissignal und korrigiert das erhaltene Zeitbasissignal zur Minimierung der ermittelten Abweichung automatisch fortlaufend oder in regelmäßigen Zeitabständen.

Bei einer möglichen Ausführungsform des erfindungsgemäßen Photovoltaik-Wechselrichters werden die durch die Kalibriereinheit ermittelten Abweichungen zwischen dem von der Empfangseinheit empfangenen Referenzsignal und dem von dem Zeitsignalgenerator erhaltenen Zeitbasissignal oder der durch die Kalibriereinheit berechnete Korrekturfaktor in einen mit der Kalibriereinheit verbundenen Datenspeicher des Photovoltaik-Wechselrichters gespeichert.

Bei einer möglichen Ausführungsform des erfindungsgemäßen Photovoltaik-Wechselrichters werden die ermittelten Abweichungen zwischen dem von der Empfangseinheit empfangenen Referenzsignal und dem von dem Zeitsignalgenerator erhaltenen Zeitbasissignal und/oder der berechnete Korrekturfaktor zusammen mit mindestens einem Betriebsparameter des Photovoltaik-Wechselrichters in dem Datenspeicher der Kalibriereinheit gespeichert, wobei der Betriebsparameter durch eine innerhalb des Gehäuses des Photovoltaik-Wechselrichters herrschende Innentemperatur, Tinnen, die durch einen Temperatursensor des Photovoltaik-Wechselrichters gemessen wird, und/oder durch eine gemessene Versorgungsspannung gebildet ist.

Bei einer möglichen Ausführungsform des erfindungsgemäßen Photovoltaik-Wechselrichters empfängt die Umwandlungsschaltung den DC-Gleichstrom von einem Photovoltaikfeld und speist den umgewandelten AC-Wechselstrom über eine steuerbare Netztrenneinrichtung in ein Stromversorgungsnetz ein.

Bei einer möglichen Ausführungsform des erfindungsgemäßen Photovoltaik-Wechselrichters ermittelt eine Messeinheit des Photovoltaik-Wechselrichters eine aktuelle Netzfrequenz eines Stromversorgungsnetzwerkes auf Grundlage des von der Kalibriereinheit korrigierten Zeitbasissignales.

Bei einer möglichen Ausführungsform des erfindungsgemäßen Photovoltaik-Wechselrichters weist der Zeitsignalgenerator einen Quarz, Resonator oder Oszillator auf, der ein oszillierendes Zeitbasissignal erzeugt und an die Kalibriereinheit des Photovoltaik-Wechselrichters überträgt.

Bei möglichen Ausführungsformen des erfindungsgemäßen Photovoltaik-Wechselrichters weist die Empfangseinheit des Photovoltaik-Wechselrichters einen Radiosignalempfänger auf, der ein Radio-Referenzsignal von einer Radiosignalquelle empfängt, oder die Empfangseinheit des Photovoltaik-Wechselrichters weist einen GPS-Empfänger auf, der ein GPS-Referenzsignal von einer GPS-Signalquelle empfängt, oder die Empfangseinheit des Photovoltaik-Wechselrichters empfängt über ein Datennetzwerk ein Referenzsignal von einem Server.

Bei einer möglichen Ausführungsform des erfindungsgemäßen Photovoltaik-Wechselrichters werden Vorgabewerte von elektrischen Strömen oder von elektrischer Leistung zur Ansteuerung von zumindest einer elektronischen Komponente oder Stufe der Umwandlungsschaltung durch die Steuereinheit des Photovoltaik-Wechselrichters auf Basis des durch die Kalibriereinheit korrigierten Zeitbasissignals oder auf Basis des durch die Kalibriereinheit berechneten Korrekturfaktors fortlaufend angepasst.

Die Erfindung schafft ferner eine Photovoltaik-Anlage mit einem Photovoltaikfeld zur Erzeugung einen DC-Gleichstrom, der durch einen Photovoltaik-Wechselrichter gemäß dem zweiten Aspekt der Erfindung in einen AC-Wechselstrom für ein Stromversorgungsnetzwerk und/oder für lokale Stromverbraucher umgewandelt wird.

Die von der Steuereinheit der Regelungseinheit bereitgestellten Vorgabewerte bzw. Sollwerte sind vorzugsweise Leistungsvorgabewerte.

Die Netzfrequenz umfasst bei einer möglichen Ausführungsform die Frequenz eines an den Photovoltaik-Wechselrichter zuschaltbaren Stromversorgungsnetzes. Dessen Netzfrequenz kann mit einer Messeinheit gemessen werden. Die Messeinheit erhält das durch die Kalibriereinheit korrigierte Zeitbasissignals und/oder den berechneten Korrekturfaktor und kann somit die Netzfrequenz des Stromversorgungsnetzes genauer bzw. präziser ermitteln.

Die Steuereinheit kann zudem sonstige elektronische Komponenten des Photovoltaik-Wechselrichters auf Basis des durch die Kalibriereinheit korrigierten Zeitbasissignals ansteuern und/oder Messungen auf Basis des durch die Kalibriereinheit korrigierten Zeitbasissignals durch mindestens eine Messeinheit des Photovoltaik-Wechselrichters veranlassen.

Bei dem erfindungsgemäßen Photovoltaik-Wechselrichter wird das lokale Zeitbasissignal korrigiert bzw. kalibriert, sodass die Genauigkeit der davon abgeleiteten Vorgabe- bzw. Sollwerte, Steuersignale und/oder Messsignale erhöht wird. Hierdurch erhöht sich die Zuverlässigkeit des Photovoltaik-Wechselrichters während des Betriebes. Darüber hinaus werden Alterungsprozesse von zeitgebenden Bauteilen innerhalb des Wechselrichters während des Betriebes fortlaufend kompensiert. Hierdurch kann die Betriebslebensdauer des Photovoltaik-Wechselrichters erheblich gesteigert werden. Darüber hinaus lässt sich eine optimierte Einspeisung von umgewandelter AC-Spannung bzw. umgewandelten AC-Wechselstrom in das Stromversorgungsnetzwerk erreichen. Hierdurch kann die Netzstabilität, insbesondere die Stabilität der Netzfrequenz des Stromversorgungsnetzwerkes gesteigert werden.

Der Photovoltaik-Wechselrichter kann auch mehrere Stromphasen L in das Stromversorgungsnetzwerk, beispielsweise in ein dreiphasiges Stromversorgungsnetzwerk einspeisen, wobei die Regelung der durch den Photovoltaik-Wechselrichter jeweils in eine Stromphase L des Stromversorgungsnetzwerkes eingespeisten elektrischen Wirk- und/oder Blindleistung mit Hilfe der von der Steuereinheit abgegebenen Vorgabe-bzw. Sollwerte für jede Stromphase L1, L2, L3 getrennt erfolgen kann.

Der Photovoltaik-Wechselrichter speist AC-Wechselstrom mit einer bestimmten Frequenz in das Stromversorgungsnetz ein. Diese Frequenz entspricht stets der aktuell gemessenen Netzspannungs-Frequenz. Dies wird z.B. durch Regelung des Phasenwinkels gewährleistet und funktioniert selbst mit einer falschen Zeitbasis. Bei dem erfindungsgemäßen Photovoltaik-Wechselrichter wird durch das Vorsehen der Kalibriereinheit verhindert, dass die resultierende Messung der Netzfrequenz durch die Messeinheit ein ungenaues bzw. falsches Ergebnis liefert.

Die Stabilisierung der Netzfrequenz f des Stromversorgungsnetzes wird indirekt durch kontinuierliche Regelung des durch den Photovoltaik-Wechselrichter in das Stromversorgungsnetz eingespeisten Stromes bzw. der darin eingespeisten elektrischen Leistung P, insbesondere der darin eingespeisten Wirkleistung, mittel fortlaufend angepasster Vorgabewerte bzw. Sollwerte erreicht.

Bei einer möglichen Ausführungsform des erfindungsgemäßen Photovoltaik-Wechselrichters werden die durch die Kalibriereinheit ermittelten Abweichungen zwischen dem von der Empfangseinheit empfangenen Referenzsignal und dem von dem Zeitsignalgenerator erhaltenen Zeitbasissignal in einen Datenspeicher der Kalibriereinheit gespeichert.

Bei einer weiteren möglichen Ausführungsform des erfindungsgemäßen Photovoltaik-Wechselrichters werden die ermittelten Abweichungen zwischen dem von der Empfangseinheit empfangenen Referenzsignal und dem von dem Zeitsignalgenerator erhaltenen Zeitbasissignal zusammen mit mindestens einem weiteren Betriebsparameter des Photovoltaik-Wechselrichters in den Datenspeicher der Kalibriereinheit gespeichert.

Bei einer weiteren möglichen Ausführungsform des erfindungsgemäßen Photovoltaik-Wechselrichters weist der Betriebsparameter eine innerhalb des Gehäuses des Photovoltaik-Wechselrichters herrschende Innentemperatur auf, die durch einen Temperatursensor des Photovoltaik-Wechselrichters gemessen wird.

Bei einer weiteren möglichen Ausführungsform des erfindungsgemäßen Photovoltaik-Wechselrichters weist der Betriebsparameter eine gemessene Versorgungsspannung auf.

Bei einer weiteren möglichen Ausführungsform des erfindungsgemäßen Photovoltaik-Wechselrichters empfängt die Umwandlungsschaltung den DC-Gleichstrom von einem Photovoltaikfeld und speist den umgewandelten AC-Wechselstrom über eine steuerbare Netztrenneinrichtung in ein Stromversorgungsnetz ein. Die Netztrenneinrichtung bietet bei Öffnung eine galvanische Trennung des Photovoltaik-Wechselrichters vom Stromversorgungsnetz. Zum Beispiel erfolgt bei unzulässigen Netzzuständen (Unter/Über-Spannung, Unter/Über-Frequenz) eine automatische Trennung des Photovoltaik-Wechselrichters von dem Stromversorgungsnetz.

Bei einer weiteren möglichen Ausführungsform des erfindungsgemäßen Photovoltaik-Wechselrichters ermittelt eine Messeinheit des Photovoltaik-Wechselrichters eine aktuelle Netzfrequenz des Stromversorgungsnetzwerkes auf Grundlage des von der Kalibriereinheit korrigierten Zeitbasissignals.

Bei einer weiteren möglichen Ausführungsform des erfindungsgemäßen Photovoltaik-Wechselrichters werden Steuersignale zur Ansteuerung der elektronischen Komponenten der Umwandlungsschaltung durch die Steuereinheit des Photovoltaik-Wechselrichters auf Basis des durch die Kalibriereinheit korrigierten Zeitbasissignals erzeugt.

Im Weiteren werden mögliche Ausführungsformen des erfindungsgemäßen Photovoltaik-Wechselrichters sowie des erfindungsgemäßen Kalibrierverfahrens unter Bezugnahme auf die beigefügten Figuren näher erläutert.

Es zeigen:
- Fig. 1: ein Blockschaltbild zur Erläuterung einer möglichen Ausführungsform eines erfindungsgemäßen Photovoltaik-Wechselrichters;
- Fig. 2A,2B: weitere Blockschaltbilder zur Erläuterung der Funktionsweise eines erfindungsgemäßen Photovoltaik-Wechselrichters innerhalb einer Photovoltaik-Anlage;
- Fig. 3: ein Ablaufdiagramm zur Erläuterung eines Ausführungsbeispiels eines erfindungsgemäßen Verfahrens zum Kalibrieren eines Zeitbasissignals bei einem Photovoltaik-Wechselrichter;
- Fig.4: ein Ablaufdiagramm zur Darstellung einer möglichen exemplarischen Implementierung eines erfindungsgemäßen Verfahrens;
- Fig. 5A-5E: Erläuterung der Funktionsweise eines erfindungsgemäßen Verfahrens.

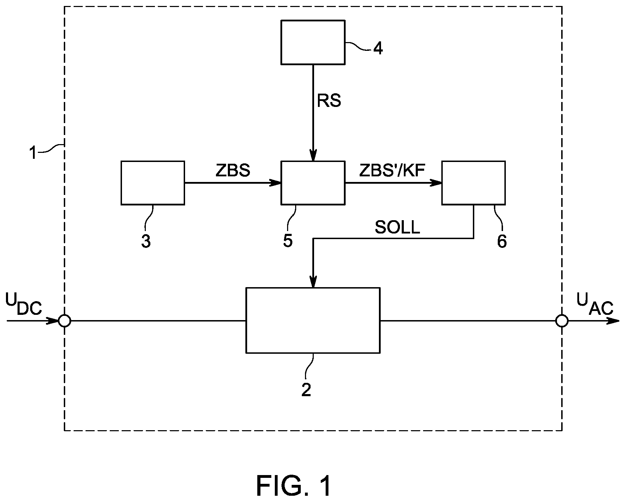

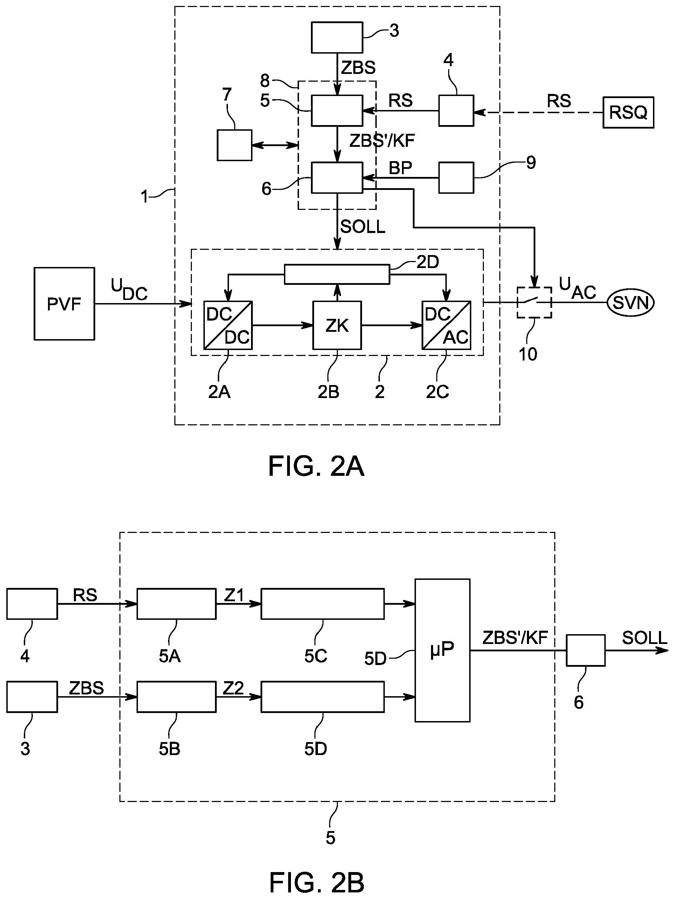

Fig. 1 stellt ein Ausführungsbeispiel eines erfindungsgemäßen Photovoltaik-Wechselrichters 1 dar. Wie aus dem dargestellten Blockschaltbild erkennbar, weist der Photovoltaik-Wechselrichter 1 eine Umwandlungsschaltung 2 auf, die einen erhaltenen DC-Gleichstrom in einen AC-Wechselstrom umwandelt. Hierzu enthält die Umwandlungsschaltung 2 verschiedene Stufen, wie auch in Fig. 2 dargestellt. Die Umwandlungsschaltung 2 enthält elektronische Komponenten, um den erhaltenen DC-Gleichstrom in den AC-Wechselstrom umzuwandeln. Neben der Umwandlungsschaltung 2 enthält der Photovoltaik-Wechselrichter 1 mindestens einen lokalen Zeitsignalgenerator 3, der ein Zeitbasissignal ZBS erzeugt. Weiterhin umfasst der Photovoltaik-Wechselrichter 1 eine Empfangseinheit 4, die zum Empfang eines Referenzsignals von einer externen Referenzsignalquelle RSQ vorgesehen ist. Die Empfangseinheit 4 gibt das empfangene Referenzsignal RS an eine Kalibriereinheit 5 des Photovoltaik-Wechselrichters 1 ab, wie im Blockschaltbild gemäß Fig. 1 dargestellt. Die Kalibriereinheit 5 korrigiert das von dem Zeitsignalgenerator 3 erhaltene Zeitbasissignal ZBS auf Grundlage des von der Empfangseinheit 4 empfangenen Referenzsignals. Die Kalibriereinheit 5 erzeugt auf diese Weise ein korrigiertes Zeitbasissignal ZBS', wie in Fig. 1 dargestellt und gibt dieses korrigierte Zeitbasissignal ZBS' an eine Steuereinheit 6 des Photovoltaik-Wechselrichters 1 weiter. Bevorzugt sind die dargestellten Funktionskomponenten, also der Zeitsignalgenerator 3, die Empfangseinheit 4 und die Kalibriereinheit 5 Teil der Steuereinheit 6, welche mit der vorhandenen Hardware diese Funktionen ausführt.

Alternativ kann die Kalibriereinheit 5 auch einen Korrekturfaktor KF berechnen und bereitstellen. Die Steuereinheit 6 stellt Vorgabewerte bzw. Sollwerte (Soll) bereit, die von der Steuereinheit 6 an eine Regelungseinheit 2D der Umwandlungsschaltung 2 übertragen werden, wie in Figur 2 gezeigt. Die Regelungseinheit 2D erzeugt Steuersignale bzw. Regelungssignale CRTL, die an die verschiedenen Stufen und/oder elektronischen Baukomponenten der Umwandlungsschaltung 2 angelegt werden. Die Regelungseinheit 2D erzeugt Steuersignale bzw. Regelungssignale CRTL, die insbesondere von der Regelungseinheit 2D an eine DC/DC Wandlerstufe 2A und/oder an eine DC/AC Wandlerstufe 2C der Umwandlungsschaltung 2 angelegt werden. Die PWM-Frequenz wird nicht korrigiert. Korrigiert werden Vorgabewerte bzw. Sollwerte von Leistungen P oder Strömen I in Abhängigkeit des korrigierten Zeitbasissignales ZBS' oder in Abhängigkeit des berechneten Korrekturfaktors KF. Durch die Korrektur des Zeitbasissignales ZBS ergibt sich eine genauere Messung und damit ein genauerer Vorgabewert des elektrischen Stroms I bzw. der elektrischen Leistung **P.** Die elektronischen Komponenten, insbesondere Leistungskomponenten, der Umwandlungsschaltung 2 werden durch die Regelungseinheit 2D entsprechend den Vorgabewerten bzw. Sollwerten geregelt, die von der Steuereinheit 6 auf Basis des durch die Kalibriereinheit 5 korrigierten Zeitbasissignals ZBS' oder des durch die Kalibriereinheit 5 berechneten Korrekturfaktors KF kontinuierlich angepasst werden. Weiterhin werden Messungen auf Basis des durch die Kalibriereinheit 5 korrigierten Zeitbasissignals ZBS' durch mindestens eine Messeinheit des Photovoltaik-Wechselrichters 1 veranlasst.

Die Kalibriereinheit 5 des Photovoltaik-Wechselrichters 1 ermittelt eine Abweichung zwischen dem durch die Empfangseinheit 4 empfangenen Referenzsignal RS und dem von dem Zeitsignalgenerator 3 erhaltenen Zeitbasissignal ZBS. Die Kalibriereinheit 5 korrigiert das erhaltene Zeitbasissignal ZBS zur Minimierung der ermittelten Abweichungen. Diese Korrektur kann bei einer möglichen Ausführungsform automatisch fortlaufend erfolgen. Alternativ erfolgt die Minimierung der ermittelten Abweichungen durch die Kalibriereinheit 5 in regelmäßigen vorgegebenen Zeitabständen.

Bei einer möglichen Ausführungsform weist der Photovoltaik-Wechselrichter 1 mindestens eine Empfangseinheit 4 auf. Bei einer möglichen Ausführungsform weist die Empfangseinheit 4 des Photovoltaik-Wechselrichters 1 einen Radiosignalempfänger auf, der ein Radio-Referenzsignal von einer externen Radiosignalquelle empfängt. Diese Radio-Referenzsignale umfassen beispielsweise Zeitfunksignale (z.B. DCF 77), welche über die vorhandenen Photovoltaikmodule als Empfänger empfangen werden und/oder mittels einer Empfangsantenne - beispielsweise gebildet durch eine vorhandene Mess-Sensorik - der Empfangseinheit 4 empfangen werden. Bei einer alternativen Ausführungsform kann die Empfangseinheit 4 des Photovoltaik-Wechselrichters 1 auch einen zusätzlichen GPS-Empfänger aufweisen, der ein GPS-Referenzsignal von einer GPS-Signalquelle empfängt. Weiterhin kann die Empfangseinheit 4 bei einer weiteren möglichen Ausführungsform auch über ein Datennetzwerk mit einem oder mehreren Servern verbunden sein. Bei dieser Ausführungsform empfängt die Empfangseinheit 4 über das Datennetzwerk - also beispielsweise ein vorhandenes WLAN-Modul oder über eine vorhandene Ethernet Schnittstelle - ein Referenzsignal RS von einem Server, welcher das Referenzsignal erzeugt. Bei einer möglichen Ausführungsform kann eine aktuelle Zeit über einen Internetzugang des Photovoltaik-Wechselrichters 1 von einem Zeitserver direkt abgefragt werden und davon ein Referenzsignal RS abgeleitet werden. Eine oder mehrere Empfangseinheiten 4 können redundant vorgesehen werden.

Fig. 2A zeigt eine Photovoltaik-Anlage, welche einen erfindungsgemäßen Photovoltaik-Wechselrichter 1 umfasst. Die Photovoltaik-Anlage enthält ein Photovoltaikfeld PVF mit einem oder mehreren Photovoltaik-Modulen PVM, die bei Sonneneinstrahlung einen DC-Gleichstrom erzeugt. Das Photovoltaik-Modulfeld kann einen oder mehrere Photovoltaik-Stränge von seriell verschaltenden Solar- bzw. Photovoltaik-Modulen PVM beinhalten. Der generierte Gleichstrom wird an eine Umwandlungsschaltung 2 des Photovoltaik-Wechselrichters 1 angelegt. Bei dem dargestellten Ausführungsbeispiel umfasst die Umwandlungsschaltung 2 drei Stufen, nämlich eine DC-DC-Wandlerstufe 2A, einen Zwischenkreis 2B sowie einen DC-AC-Wandler 2C. Die verschiedenen Stufen 2A, 2B, 2C werden durch Steuersignale bzw. Regelungssignale CRTL geregelt, welche durch die Regelungseinheit 2D entsprechend den von der Steuereinheit 6 bereitgestellten Sollwerten bzw. Vorgabewerten (SOLL) des Photovoltaik-Wechselrichters 1 erzeugt werden. Bei dem in Fig. 2A dargestellten Ausführungsbeispiel können die durch die Kalibriereinheit 5 ermittelten Abweichungen zwischen dem von der Empfangseinheit 4 empfangenen Referenzsignal RS und dem von dem Zeitsignalgenerator 3 erhaltenen Zeitbasissignal ZBS in einen Datenspeicher 7 eingeschrieben bzw. gespeichert. Dieser Datenspeicher 7 kann auch in der Kalibriereinheit 5 integriert sein. Weiterhin kann die Kalibriereinheit 5 und die Steuereinheit 6 in einer Recheneinheit 8 des Photovoltaik-Wechselrichters 1 integriert sein, wie in Fig. 2A angedeutet.

Fig. 2B zeigt ein Ausführungsbeispiel einer Kalibriereinheit 5 des Photovoltaik-Wechselrichters 1.Die Kalibriereinheit 5 hat zwei digitale Zähler 5A,5B. Der erste Zähler 5A wird durch das empfangene Referenzsignal RS, beispielsweise einem Radiosignal DCF 77, das eine Frequenz von 77,5kHZ aufweist, getaktet. Der zweite Zähler 5B wird durch das von dem lokalen Zeitsignalgeber 3 erzeugt lokale Zeitbasissignal ZBS getaktet, das beispielsweise eine relativ hohe Taktfrequenz von 16MHz aufweist. Die Zählerwerte Z1, Z2 der beiden Zähler 5A,5B werden in zugehörigen Registern bzw. Zwischenspeichern 5C,5D zwischengespeichert. Die Zähler 5A,5B sind beispielsweise 32-Bit Counter oder 64-bit Counter. Eine Recheneinheit, insbesondere ein Mikroprozessor 5D, ermittelt aus den in den Registern 5C,5D zwischengespeicherten Zählerwerten Z1, Z2 der beiden Zähler 5A,5B eine Differenz und berechnet in Abhängigkeit von der Abweichung einen Korrekturfaktor KF und/oder korrigiert das Zeitbasissignal ZBS in Abhängigkeit der ermittelten Abweichung. Das korrigierte Zeitbasissignal ZBS' oder der Korrekturfaktor KF werden durch die Kalibriereinheit 5 der daran angeschlossenen Steuereinheit 6 zur Anpassung der Sollwerte bzw. Vorgabewerte (SOLL) bereitgestellt, welche die Steuereinheit 6 an die Regelungseinheit 2D der Umwandlungsschaltung 2 anlegt.

Die Kalibriereinheit 5 erlaubt es auch Photovoltaik-Wechselrichter 1, die vor Ort bei Nutzern bereits verbaut sind und die nur über einen veralteten Oszillator bzw. Zeitsignalgeber 3 mit nur relativ ungenauem Zeitbasissignal ZBS verfügen, weiter zu betreiben und deren Frequenzmessgenauigkeit mit Hilfe des empfangenen Referenzsignales RS ohne Austausch des in dem Photovoltaik-Wechselrichter 1 verbauten (veralteten) Zeitbasissignalgebers 3 zu steigern. Man hat somit eine Upgrade-Möglichkeit durch Softwareanpassung ohne verbaute Hardware anpassen oder austauschen zu müssen.

Die ermittelten Abweichungen zwischen dem von der Empfangseinheit 4 empfangenen Referenzsignal RS und dem von dem Zeitsignalgenerator 3 erhaltenen Zeitbasissignal ZBS können bei einer möglichen Ausführungsform zusammen mit mindestens einem Betriebsparameter BP des Photovoltaik-Wechselrichters 1 in den Datenspeicher 7 der Kalibriereinheit 5 gespeichert werden. Bei einer möglichen Ausführungsform ist der Betriebsparameter BP eine innerhalb des Gehäuses des Photovoltaik-Wechselrichters 1 herrschende Innentemperatur T. Diese Temperatur T kann beispielsweise durch einen Temperatursensor 9 des Photovoltaik-Wechselrichters 1 fortlaufend gemessen werden. Der Temperatursensor 9 übermittelt den gemessenen Betriebsparameter BP bzw. die Innentemperatur T an die Steuereinheit 6, welche den Betriebsparameter BP zusammen mit dem erhaltenen Zeitbasissignal ZBS als Datensatz in den Datenspeicher 7 ablegt. Alternativ kann der Betriebsparameter BP auch eine gemessene Versorgungsspannung umfassen. Die Kalibriereinheit 5 des Photovoltaik-Wechselrichters 1 korrigiert dann vorzugsweise das von dem Zeitsignalgenerator 3 erhaltene Zeitbasissignal ZBS zusätzlich in Abhängigkeit von mindestens einem weiteren in dem Datenspeicher 7 der Kalibriereinheit 5 gespeicherten Betriebsparameter BP. Beispielsweise erfolgt eine Korrektur selbst bei temporär nicht verfügbaren Referenzsignal RS in Abhängigkeit der gemessenen Innentemperatur Tᵢₙₙₑₙ, welche durch den Temperatursensor 9 des Photovoltaik-Wechselrichters 1 gemessen wird.

Die Umwandlungsschaltung 2 erhält den DC-Gleichstrom von dem Photovoltaikfeld und speist den umgewandelten AC-Wechselstrom bei einer möglichen Ausführungsform über eine steuerbare Netztrenneinrichtung 10 in ein Stromversorgungsnetz SVN ein. Der erzeugte Wechselstrom kann zusätzlich auch zur Versorgung lokaler elektrischer Stromverbrauchseinheiten verwendet werden. Bei einer weiteren möglichen Ausführungsform verfügt der Photovoltaik-Wechselrichter 1 auch über mindestens eine Messeinheit, welche eine aktuelle Netzfrequenz f des Stromversorgungsnetzwerkes SVN auf Grundlage des von der Kalibriereinheit 5 korrigierten Zeitbasissignals ZBS' ermittelt. Die Netzfrequenz f des Stromversorgungsnetzwerkes SVN liegt beispielsweise bei 50 oder 60 Hz. Schwankungen der Netzfrequenz können durch die Messeinheit des Photovoltaik-Wechselrichters 1 auf Grundlage des korrigierten Zeitbasissignals ZBS' genau ermittelt werden. Auf Grundlage der erfolgten Messung kann die Einspeisung des erzeugten AC-Wechselstromes durch die Steuereinheit 6 genauer gesteuert werden. Steigt beispielsweise die Netzfrequenz f des Stromversorgungsnetzwerkes SVN über einen Grenzwert, so soll bzw. muss der erzeugte Wechselstrom verkleinert werden, um die Netzfrequenz f des Stromversorgungsnetzes SVN zu stabilisieren. Sinkt beispielsweise die Netzfrequenz f des Stromversorgungsnetzwerkes SVN unter einen Grenzwert, so soll bzw. muss der erzeugte Wechselstrom vergrößert werden, um die Netzfrequenz f des Stromversorgungsnetzes SVN zu stabilisieren.

Bei unzulässigen bzw. bei größeren Frequenzänderungen muss jedoch die Stromeinspeisung gestoppt werden. In diesem Fall wird die Netztrenneinrichtung 10 geöffnet und trennt den Photovoltaik-Wechselrichter bzw. den Inverter 1 vom Stromversorgungsnetz SVN.

Bei nur geringfügigen Frequenzänderungen der Netzfrequenz f, d.h. bei Änderung noch innerhalb der Grenzwerte, kann der eingespeiste Wechselstrom angepasst werden. In diesem Fall hat die Netztrenneinrichtung 10 keinen Einfluss und wird nicht geöffnet.

Bei einer möglichen Ausführungsform weist der Zeitsignalgenerator 3 einen Quarz, Resonator oder Oszillator auf, der ein oszillierendes Zeitbasissignal ZBS erzeugt und an die Kalibriereinheit 5 des Photovoltaik-Wechselrichters 1 überträgt. Der Zeitsignalgenerator 3 erzeugt ein periodisches bzw. oszillierendes Zeitsignal. Der Zeitsignalgenerator 3 weist dazu eine Schaltung auf, die elektrische Spannung mit einem charakteristischen Zeitverlauf erzeugt. Die Schaltung kann beispielsweise einen Schwingquarz enthalten, der zur Erzeugung von elektrischen Schwingungen mit einer bestimmten Frequenz vorgesehen ist. Der Schwingquarz wird hierzu beidseitig mit Elektroden versehen, die an ein von einem beliebigen Oszillator erzeugtes Wechselfeld angelegt werden. Als Folge davon kann die Frequenz des Wechselfeldes mit der mechanischen Eigenfrequenz des Schwingquarzes in Übereinstimmung gebracht werden. Hierdurch kann der Schwingquarz wie ein elektrischer Resonanzkreis mit sehr geringer Dämpfung schwingen bzw. oszillieren. Die elektronischen Komponenten des Zeitbasissignalgenerators 3 unterliegen allerdings einer zeitlichen Alterung, die bei dem erfindungsgemäßen Photovoltaik-Wechselrichter 1 mittels des empfangenen Referenzsignals RS ausgeglichen bzw. korrigiert werden. Der Zeitsignalgenerator 3 kann auch andere Schaltungen umfassen, beispielsweise eine PLL-Schaltung zur Generierung eines Zeitbasissignals ZBS.

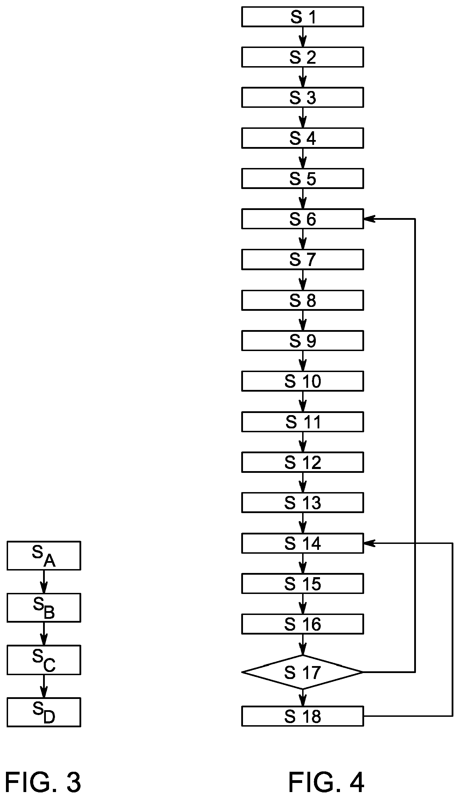

Fig. 3 zeigt ein Ablaufdiagramm einer möglichen Ausführungsform des erfindungsgemäßen Verfahrens zum Kalibrieren eines Zeitbasissignals ZBS bei einem Photovoltaik-Wechselrichter 1.

Bei dem in Fig. 3 dargestellten Ausführungsbeispiel umfasst das erfindungsgemäße Verfahren im Wesentlichen vier Hauptschritte S-A bis S-D.

In einem ersten Schritt S-A wird ein Referenzsignal RS durch eine Empfangseinheit 4 des Photovoltaik-Wechselrichters 1 von einer externen Referenzsignalquelle RSQ empfangen. Das Referenzsignal RS ist bei einer möglichen Ausführungsform ein Radio-Referenzsignal. Das Referenzsignal RS kann als Taktsignal CLK für einen ersten Zählers 5A dienen, wie auch in Fig.2B dargestellt.

Anschließend wird in einem weiteren Schritt S-B eine Abweichung zwischen dem empfangenen Referenzsignal RS und dem momentanen Zeitbasissignal ZBS, das durch den Zeitsignalgenerator 3 des Photovoltaik-Wechselrichters 1 erzeugt wird, ermittelt. Das lokal erzeugte Zeitbasissignal ZBS kann als Taktsignal CLK einem zweiten Zähler 5B zugeführt werden. Die zwischengespeicherten Zählerstände Z1,Z2 der beiden Zähler 5A,5B werden miteinander zur Bestimmung der Abweichung bzw. Differenz verglichen. Die Ermittlung der Abweichung bzw. Differenz kann bei einer möglichen Variante automatisch fortlaufend erfolgen. Alternativ wird die Abweichung in regelmäßigen vorgegebenen Zeitabständen ermittelt.

In einem weiteren Schritt S-C wird das erzeugte Zeitbasissignal ZBS zur Minimierung der ermittelten Abweichung(en) automatisch angepasst und so korrigiert. Alternativ kann auch ein Korrekturfaktor KF berechnet werden. Die Berechnung des Korrekturfaktors KF geschieht beispielsweise durch einen Mikroprozessor 5D auf Grundlage in Registern 5C,5D zwischengespeicherter Zählerwerte Z1, Z2 der beiden Zähler 5A,5B.

Anschließend werden in einem Schritt S-D die Vorgabewerte bzw. Sollwerte (Soll) für eine Regelung der elektrischen Ströme I und/oder elektrischen Leistung P in Abhängigkeit des korrigierten Zeitbasissignales ZBS' oder des berechneten Korrekturfaktors KF angepasst. Es werden durch eine Regelung 2D Steuersignale bzw. die Regelungssignale CRTL für Komponenten oder Stufen 2A, 2C der Umwandlungsschaltung 2 des Photovoltaik-Wechselrichters 1 entsprechend den angepassten Vorgabewerten bzw. Sollwerten (SOLL) erzeugt.

Weiterhin kann das korrigierte Zeitbasissignal ZBS' auch die Grundlage für Messungen bilden, die beispielsweise eine aktuelle Netzfrequenz f des Stromversorgungsnetzes SVN ermitteln. Hierdurch kann die Netzfrequenz f des Stromversorgungsnetzwerkes SVN mit einer höheren Genauigkeit bzw. zeitlichen Auflösung ermittelt werden und kritische Zustände des Stromversorgungsnetzwerkes SVN hinsichtlich seiner Netzfrequenz f korrekter bzw. präziser erkannt werden. Demzufolge können auch Gegenmaßnahmen zur Erreichung einer höheren Netzwerkstabilität seitens der Steuereinheit 6 präziser gesteuert werden. Die Amplitude des eingespeisten AC-Wechselstroms und somit die eingespeiste elektrische Leistung P kann bei Bedarf aufgrund der mit Hilfe des korrigierten Zeitbasissignales ZBS' präzise gemessenen Netzfrequenz f des Stromversorgungsnetzes SVN angepasst werden. Diese Anpassung kann erfolgen solange die Netzfrequenz f nur leicht von einer Soll-Netzfrequenz abweicht und noch innerhalb eines Grenzwertbereiches liegt. Bei stärkeren Abweichungen der gemessenen Netzfrequenz f von der Soll-Netzfrequenz, erfolgt ein automatisches Öffnen der Netztrenneinrichtung 10 durch die Steuerung 6 des Photovoltaik-Wechselrichters 1.

Der Photovoltaik-Wechselrichter 1 wird den von ihm erzeugten AC-Wechselstrom stets mit der gerade gemessenen aktuellen Netzspannungsfrequenz f in das Stromversorgungsnetz SVN einspeisen, sofern die Netztrenneinrichtung 10 geschlossen ist.

Der erfindungsgemäße Photovoltaik-Wechselrichter 1 weist gegenüber herkömmlichen Photovoltaik-Wechselrichtern eine höhere Performance bzw. Leistungsfähigkeit hinsichtlich der durchgeführten Einspeisung von Wechselstrom in das Stromversorgungsnetzwerk SVN auf, da die Einspeisung aufgrund einer zeitlich genaueren Messung durchgeführt werden kann. Darüber hinaus weist der erfindungsgemäße Photovoltaik-Wechselrichter 1 eine längere Betriebslebensdauer auf, da Alterungsprozesse elektronischer Komponenten, insbesondere elektronischer Komponenten der Umwandlungsschaltung 2, fortlaufend kompensiert werden.

Fig. 4 zeigt ein Ablaufdiagramm zur Darstellung eines Ausführungsbeispiels zur Erläuterung einer möglichen Implementierung des erfindungsgemäßen Verfahrens zum Kalibrieren eines Zeitbasissignals ZBS bei einem Photovoltaik-Wechselrichter 1.

In einem ersten Schritt S1 wird ein Zähler n auf einen Initialwert 0 gesetzt ((n)=0). In einem weiteren Schritt S2 wird entweder direkt die Uhrzeit ermittelt bzw. abgefragt oder der Zählerstand Z eines Referenzsignalzählers - also das Referenzsignal RS, beispielsweise des in Fig. 2B dargestellten Zählers 5A, ausgelesen und in einen entsprechenden Datenspeicher oder Register abgespeichert, beispielsweise in das in Fig. 2B dargestellte Register 5C.

In einem weiteren Schritt S3 wird der Zählerstand eines weiteren Zählers, der von dem Zeitsignalgenerator 3 getaktet wird, ausgelesen und abgespeichert. Beispielsweise wird der Zählerstand Z2 - also das Zeitbasissignal ZBS - des Zählers 5B in Fig. 2B im Schritt S3 ausgelesen und in den Register 5D zwischengespeichert.

In einem weiteren Schritt S4 kann eine neue Wartezeit bis zum nächsten Messzeitpunkt festgelegt und zwischengespeichert werden. Im darauffolgenden Schritt S5 wird bis zu diesem festgelegten neuen Messzeitpunkt gewartet.

Anschließend wird im Schritt S6 der im Schritt S1 initialisierte Zähler n inkrementiert ((n)=(n)+1). In einem Schritt S7 wird erneut die Uhrzeit ermittelt oder der Zählerstand Z1 - also das Referenzsignal RS - des Referenzsignalzählers, **d.h.** des Zählers 5A, ausgelesen und in dem zugehörigen Register 5C abgespeichert.

Daraufhin erfolgt im Schritt S8 ein Auslesen des Zählerstandes Z2 des von dem Zeitbasissignal ZBS getakteten Zählers 5B und die Zwischenspeicherung des ausgelesenen Zählerstandes Z2 in den zugehörigen Register 5D.

In einem weiteren Schritt S9 wird die Differenz zwischen den Zählerständen Z1,Z2 der beiden Zähler 5A, 5B von dem letzten Messzeitpunkt n-1 durch die Recheneinheit bzw. den Prozessor 5D ermittelt. $DeltaZBS \left(n\right) = ZBS \left(n\right) - ZBS \left(n-1\right)$ $DeltaRS \left(n\right) = RS \left(n\right) - RS \left(n-1\right)$

In einem weiteren Schritt S10 erfolgt eine Ermittlung der vergangenen Zeitdifferenzen zum letzten Messzeitpunkt (n-1). $DeltaZeitZBS \left(n\right) = DeltaZBS \left(n\right) / FrequenzZBS$ $DeltaZeitRS \left(n\right) = DeltaRS \left(n\right) / FrequenzRS ,$ wobei FrequenzZBS die lokale Frequenzrate des Zeitbasissignals ZBS ist und wobei die Zeit der FrequenzRS die Frequenz des Referenzsignals RS ist. $DeltaZeitRS \left(n\right) = RS \left(n\right) - RS \left(n-1\right)$

Diese Formel ist zu verwenden, wenn das Referenzsignal keine Frequenz aufweist, wie beispielsweise bei Variante B.

In den Schritten S9 und S10 wird also die Abweichung bzw. eine zeitliche Abweichung ermittelt, welche für das folgende Korrigieren (S-C) des Zeitbasissignals (ZBS) zur Minimierung der ermittelten Abweichung oder Berechnen eines Korrekturfaktors (KF) erforderlich ist.

In einem weiteren Schritt S11 erfolgt eine Ermittlung eines relativen Fehlers des lokalen Oszillators bzw. des lokalen Zeitsignalgenerators 3. Es wird also das korrigierte Zeitbasissignal ZBS' oder der Korrekturfaktor KF wie folgt ermittelt bzw. berechnet: $ErrorZBS \left(n\right) = DeltaZeitZBS \left(n\right) / DeltaZeitRS \left(n\right)$

In einem weiteren Schritt S12 kann optional eine Ermittlung der Umgebungsbedingungen UmgebungLoc (n) des lokalen Zeitsignalgenerators 3 erfolgen. Es werden beispielsweise die lokale Temperatur T oder eine lokale Versorgungsspannung ermittelt.

In einem weiteren Schritt S13 wird optional der ermittelte relative Fehler des lokalen Zeitsignalgenerators 3 ErrorZBS (n) in Abhängigkeit der im Schritt S12 ermittelten Umgebungsbedingungen UmgebungLoc (n) in einem ein- oder mehrdimensionalen Feld bzw. Datenarray in einem Datenspeicher abgespeichert. Alternativ kann ein verbesserter Parameter für eine Fit-Formel im Schritt S13 berechnet werden, welche den Fehler in Abhängigkeit von den ermittelten Umgebungsbedingungen beschreibt, beispielsweise eine Temperaturabhängigkeit von Schwingquarzen.

In einem weiteren Schritt S14 wird der relative Fehler des lokalen Zeitsignalgenerators 3 ErrorZBS (n) für die Korrektur von zeitbehafteten Werten, Parametern und/oder Einstellungen bereitgestellt. Ebenfalls werden Korrekturen durchgeführt und/oder eine Berechnungsroutine angestoßen.

In einem weiteren Schritt S15 kann eine neue Wartezeit bis zu einem nächsten Messzeitpunkt festgelegt werden.

In dem anschließenden Schritt S16 wird bis zu diesem neuen Messzeitpunkt gewartet.

Im Schritt S17 wird festgestellt, ob eine Referenzsignalquelle RSQ verfügbar ist bzw. ob ein Referenzsignal RS von der Empfangseinheit 4 empfangen wird. Ist dies der Fall, kehrt der Vorgang zu Schritt S6 zurück, wie im Ablaufdiagramm gemäß Fig. 4 erkennbar. Ist umgekehrt keine Referenzsignalquelle RSQ verfügbar, erfolgt im Schritt S18 die Ermittlung eines neuen Fehlers aufgrund der Umgebungsbedingungen und aufgrund der in dem ein- oder mehrdimensionalen Datenfeld gespeicherten Informationen. Alternativ kann auch die Berechnung eines Fehlers aufgrund der Fit-Formel erfolgen. Anschließend kehrt der Vorgang zu Schritt S14 zurück, wie in Fig. 4 dargestellt.

Allgemein setzt sich der ermittelte Fehler aus dem gesuchten Fehler des lokalen Oszillators 3, einem Fehler der Referenzsignalquelle RSQ und einem Fehler zusammen, der bei der Ermittlung der Referenz auftritt. Dieser letztgenannte Fehler ist absolut und kann beispielsweise bei abgefragter Internetzeit bei etwa 10 msec liegen. Der Fehler der Referenzsignalquelle RSQ ist typischerweise sehr niedrig und daher oft vernachlässigbar. Beispielsweise liegt bei einer DCF 77 Radiosignalquelle der Frequenzfehler über 24 Stunden bei 2⁻¹². Die Wartezeit wird derart groß genug gewählt werden, um aus dem absoluten Fehler einen relativ kleinen Fehler zu erhalten, um diesen dann vernachlässigen zu können.

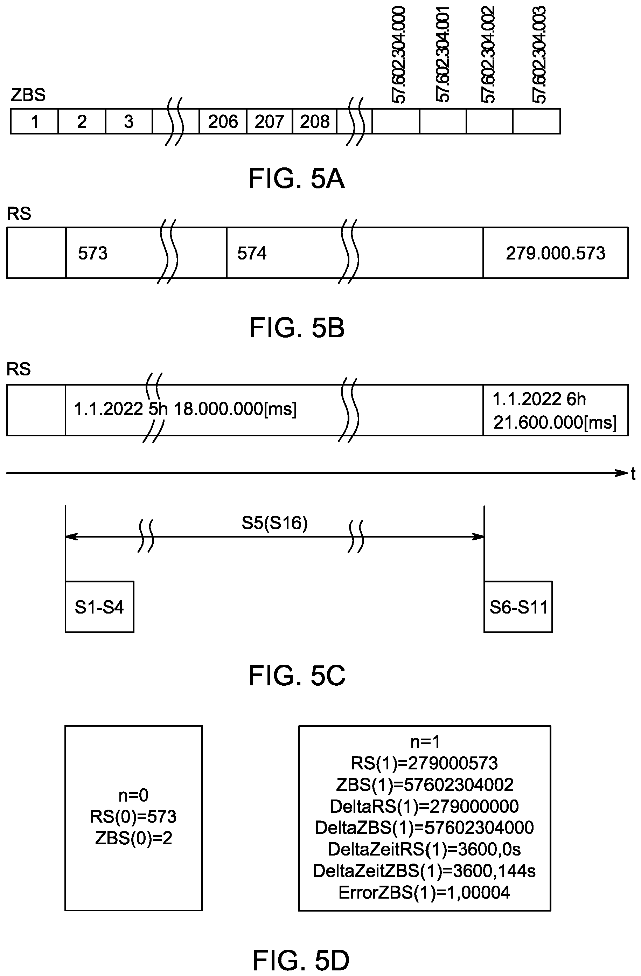

Die im Folgenden beschriebenen Fig. 5A bis Fig. 5E sind zeitlich abgestimmt und zeigen die wesentlichen Schritte gemäß Fig. 4.

Fig. 5A zeigt beispielhaft unterschiedliche Werte bei einem entsprechenden Ablauf bzw. ausgeführten Programm gemäß Fig. 4. Wie dargestellt, liefert der Zeitsignalgenerator 3 beispielsweise ein Zeitbasissignal ZBS mit einer Frequenz von 16 MHz. Dieses Zeitbasissignal ZBS wird von dem lokalen Oszillator bzw. dem Zeitsignalgenerator 3 als Taktsignal an den Zähler 5B zum Zählen der Impulse angelegt. Die unterschiedlichen Werte zeigen die Zählwerte Z2 des Zählers 5B. Beispielsweise wird mit Zählwert 1 gestartet. Bei dem Zählwert 206 sind in etwa 13µs vergangen, bei dem Zählwert 57.600.000.000 wäre eine Stunde vergangen, wenn das Taktsignal genau ist bzw. keine Abweichungen aufweist. Ist das Taktsignal allerdings ungenau bzw. weist Abweichungen auf, liegt beispielsweise nach einer Stunde ein Zählwert von 57.602.304.000 vor, wie in Fig. 5A dargestellt.

Die folgenden Fig. 5B und Fig. 5C zeigen zwei Varianten VarA, VarB zur Ermittlung einer Referenzzeit.

Bei der ersten Variante VarA gemäß Fig. 5B wird ein Referenzradiosignal RS durch die Empfangseinheit 4 von einer Radiosignalquelle DCF 77 mit einer Taktfrequenz von 77,5 KHz empfangen und ein entsprechender Zähler 5A zählt die Impulse des empfangenen Referenzsignals RS. Zum demjenigen Zeitpunkt, an dem der Zähler 5B mit dem Zählwert 1 startet, hat der Zähler 5A in dem dargestellten Beispiel einen Wert von 573. Nach etwa 13µs erhöht sich der Zählwert des Zählers 5A um den Wert 1 auf den Wert 574. Nach einer Stunde ist dann der Wert 279.000.573 erreicht, wie in Fig. 5B dargestellt.

Durch die unterschiedlichen Frequenzen von Referenzsignal RS und von Zeitbasissignal ZBS ist auch die Dauer der Impulse - wie dargestellt- unterschiedlich lang.

Alternativ kann gemäß der zweiten Variante VarB gemäß Fig. 5C direkt die Referenzzeit beispielsweise durch eine Internetabfrage ermittelt werden und anschließend in absolute Millisekunden umgerechnet werden, wie ebenfalls in Fig. 5C dargestellt. Hierbei werden keine Impulse bzw. keine Zähler verwendet, sondern die Abfrage erfolgt nach Bedarf.

Die Wartezeit zwischen zwei Messungen kann beispielsweise 3.600 sec, d.h. eine Stunde, betragen. Ist jedoch entsprechend individuell wählbar.

Fig. 5D zeigt beispielhaft entsprechend ermittelte Werte zu zwei Messzeitpunkten, welche gemäß einer Wartezeit von 3.600 sec. auseinanderliegen. Als Referenzsignal RS wird hier Variante VarA (Fig. 5B) gewählt (siehe dazu die Werte in dem linken Kästchen von Fig. 5D).

Die Messzeitpunkte sind entsprechend auf die Wartezeit synchronisiert, wobei die Wartezeit beispielsweise vom Referenzsignal RS überwacht wird. Das heißt, dass sowohl der Wert des Referenzsignals RS als auch der Wert des Zeitbasissignals ZBS mit Ablauf der Wartezeit ausgelesen bzw. abgefragt werden.

Diese aktuellen Werte werden entsprechend zur Berechnung des Korrekturfaktors KF herangezogen.

Der erste Messzeitpunkt, also n=0, liegt beim zweiten Impuls des ZBS, daher ZBS = 2. Zu diesem Zeitpunkt hat der Zähler 5A einen Wert von 573, wobei dies dem Wert für das Referenzsignal RS entspricht.

Der zweite Messzeitpunkt, also n=1, liegt beim Impuls mit dem Zählerwert 57.602.304.002 (= ZBS) nach der Wartezeit von einer Stunde. Das Referenzsignal RS hat entsprechend den Wert einer Stunde später, also RS = 279.000.573.

Die weiteren Werte im Kästchen rechts in Fig. 5D zeigen: DeltaRS = 279.000.573 minus 573 = 279.000.000 DeltaZBS = 57.602.304.002 minus 2 = 57.602.304.000 DeltaZeitRS = 279.000.000 / 77.5kHz = 3600 sec DeltaZeitZBS = 57.602.304.000 / 16MHz = 3600,144 sec ErrorZBS = 3600,144 / 3600 = 1,00004 = Korrekturfaktor KF

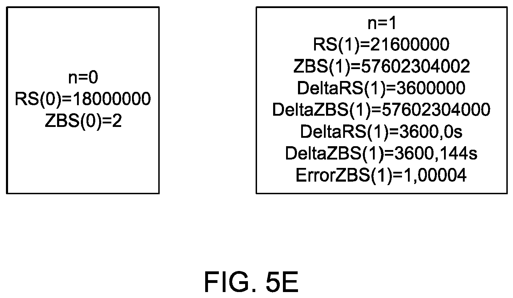

Fig. 5E zeigt beispielhaft entsprechend ermittelte Werte zu zwei Messzeitpunkten, welche gemäß der Wartezeit 3.600 sec. auseinanderliegen. Als RS ist hier Variante VarB (Fig. 5C) gewählt (Siehe dazu die Werte in dem linken Kästchen von Fig. 5E).

Die Messzeitpunkte sind entsprechend auf die Wartezeit synchronisiert, wobei die Wartezeit beispielsweise vom Referenzsignal RS überwacht wird. Das heißt, dass sowohl der Wert des Referenzsignals RS als auch der Wert des Zeitbasissignals ZBS mit Ablauf der Wartezeit ausgelesen bzw. abgefragt werden. Diese aktuellen Werte werden entsprechend zur Berechnung des Korrekturfaktors KF herangezogen.

Der erste Messzeitpunkt, also n=0, liegt beim zweiten Impuls des ZBS, daher ZBS = 2. Zu diesem Zeitpunkt wird auch das Referenzsignal RS aus dem Internet abgefragt (Variante VarB) und ergibt in dem dargestellten Beispiel einen Wert von 18.000.000 ms (= RS) - also fünf Stunden nach Mitternacht / 5h.

Der zweite Messzeitpunkt, also n=1, ist beim Impuls mit dem Zählerwert 57.602.304.002 (= ZBS) nach der Wartezeit von einer Stunde. Das Referenzsignal RS hat entsprechend den Wert einer Stunde später (also 6 Uhr / 6h früh), also RS = 21.600.000 ms.

Die weiteren Werte im Kästchen rechts in Fig. 5E zeigen: DeltaRS = 21.600.000 ms minus 18.000.000 ms = 3.600.000 ms DeltaZBS = 57.602.304.002 minus 2 = 57.602.304.000 DeltaZeitRS = DeltaRS $DeltaZeitZBS = 57.602.304.000 / 16 MHz = 3600 , 144 sec$ 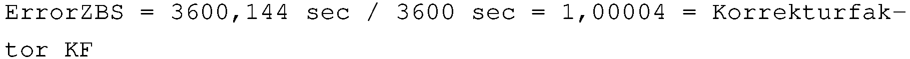 ErrorZBS = 3600,144 sec / 3600 sec = 1,00004 = Korrekturfaktor KF

Zusammenfassend gilt für Fig. 5D und Fig. 5E:
Ab dem zweiten Messzeitpunkt kann also ein Korrekturfaktor KF gegenüber dem vorherigen Messzeitpunkt ermittelt werden.

Der Korrekturfaktor KF ist dabei entsprechend unabhängig von der verwendeten Referenz. Wie oben anhand des Beispiels dargelegt ergibt sich sowohl bei Variante VarA (Fig. 5B, Fig. 5D) als auch bei Variante VarB (Fig. 5C, Fig. 5E) ein identischer Korrekturfaktor KF (in dem dargestellten Beispiel: KF = ErrorZBS(1)=1,00004).

Der Korrekturfaktor KF kann sowohl zum Messzeitpunkt als auch in Bezug zur Umgebungstemperatur T abgespeichert werden. Der zusätzliche Bezug zu einer Temperatur, insbesondere Umgebungstemperatur, kann beispielsweise dann verwendet werden, wenn das Referenzsignal RS nicht verfügbar ist. Dementsprechend wird die Umgebungstemperatur T ermittelt (siehe auch Schritte S12 und S13 in Fig. 4).

In dem dargestellten Beispiel beträgt der relative Fehler 0,144 sec pro Stunde (3.600 sec). Dieser relative Fehler wird als Korrekturfaktor KF zur automatischen Korrektur des Zeitbasissignals ZBS und/oder zur Anpassung der Regelungs-Vorgabewerte (Soll) herangezogen werden (Siehe auch Schritt S14 in Fig. 4).

## Patentansprüche

1. Verfahren zum Kalibrieren eines Zeitbasissignales (ZBS) bei einem Photovoltaik-Wechselrichter (1), welcher eine Umwandlungsschaltung (2) mit Komponenten zur Umwandlung eines DC-Gleichstroms in einen AC-Wechselstrom aufweist, mit den folgenden Schritten:
- Empfangen (S-A) eines Referenzsignales (RS) durch eine Empfangseinheit (4) des Photovoltaik-Wechselrichters (1) von einer externen Referenzsignalquelle (RSQ);
- Ermitteln (S-B) einer Abweichung zwischen dem empfangenen Referenzsignal (RS) und einem Zeitbasissignal (ZBS), das durch einen lokalen Zeitsignalgenerator (3) des Photovoltaik-Wechselrichters (1) erzeugt wird, wobei das Zeitbasissignal (ZBS) durch ein Taktsignal gebildet wird;
- Korrigieren (S-C) des Zeitbasissignals (ZBS) zur Minimierung der Abweichung oder Berechnen eines Korrekturfaktors (KF),
wobei das von dem Zeitsignalgenerator (3) erzeugte Zeitbasissignal (ZBS) bei verfügbarem Referenzsignal (RS) in Abhängigkeit von dem Referenzsignal (RS) automatisch korrigiert wird, und
wobei das von dem Zeitsignalgenerator (3) erzeugte Zeitbasissignal (ZBS) bei temporär nicht verfügbarem Referenzsignal (RS) in Abhängigkeit von mindestens einem gespeicherten Betriebsparameter (BP) automatisch korrigiert wird, welcher durch eine innerhalb des Gehäuses des Photovoltaik-Wechselrichters (1) herrschende gemessene Innentemperatur und/oder durch eine gemessene Versorgungsspannung gebildet wird; und
- Anpassen (S-D) von Vorgabewerten (SOLL) für zumindest eine Komponente der Umwandlungsschaltung (2) in Abhängigkeit des korrigierten Zeitbasissignales (ZBS') oder in Abhängigkeit des berechneten Korrekturfaktors (KF).

2. Verfahren nach Anspruch 1,
wobei das Zeitbasissignal (ZBS) zur Minimierung der ermittelten Abweichung automatisch fortlaufend oder in regelmäßigen Zeitabständen korrigiert wird.

3. Verfahren nach Anspruch 1 oder 2,
wobei die ermittelten Abweichungen zwischen dem von der Empfangseinheit (4) empfangenen Referenzsignal (RS) und dem von dem Zeitsignalgenerator (3) erzeugten Zeitbasissignal (ZBS) und/oder der berechnete Korrekturfaktor (KF) zusammen mit mindestens dem Betriebsparameter (BP) des Photovoltaik-Wechselrichters (1) in einen Datenspeicher (7) einer Kalibriereinheit (5) des Photovoltaik-Wechselrichters (1) gespeichert werden.

4. Verfahren nach Anspruch 3,
wobei die innerhalb des Gehäuses des Photovoltaik-Wechselrichters (1) herrschende Innentemperatur durch einen Temperatursensor (9) des Photovoltaik-Wechselrichters (1) gemessen wird.

5. Photovoltaik-Wechselrichter (1) mit:
- einer Umwandlungsschaltung (2), welche elektronische Komponenten aufweist, die einen erhaltenen DC-Gleichstrom in einen AC-Wechselstrom umwandeln;
- einem Zeitsignalgenerator(3) der ein Zeitbasissignal (ZBS) erzeugt, das ein Taktsignal aufweist;
- einer Empfangseinheit (4) die zum Empfang eines Referenzsignales (RS) von einer externen Referenzsignalquelle (RSQ) vorgesehen ist;
- einer Kalibriereinheit (5) welche das Zeitbasissignal (ZBS) von dem Zeitsignalgenerator (3) erhält und das Zeitbasissignal (ZBS) auf Grundlage des von der Empfangseinheit (4) empfangenen Referenzsignales (RS) automatisch korrigiert oder einen Korrekturfaktor (KF) berechnet,
wobei die Kalibriereinheit (5) dazu eingerichtet ist, das von dem Zeitsignalgenerator (3) erzeugte Zeitbasissignal (ZBS):
• bei verfügbarem Referenzsignal (RS) in Abhängigkeit von dem Referenzsignal (RS) automatisch zu korrigieren, und
• bei temporär nicht verfügbarem Referenzsignal (RS) in Abhängigkeit von mindestens einem in einem Datenspeicher (7) des Photovoltaik-Wechselrichters (1) gespeicherten Betriebsparameter (BP) automatisch zu korrigieren, welcher durch eine innerhalb des Gehäuses des Photovoltaik-Wechselrichters (1) herrschende Innentemperatur, und/oder durch eine gemessene Versorgungsspannung gebildet ist; und mit
- einer Steuereinheit (6), die einen oder mehrere Vorgabewerte (SOLL) für eine Regelungseinheit (2D) der Umwandlungsschaltung (2) des Photovoltaik-Wechselrichters (1) in Abhängigkeit des korrigierten Zeitbasissignales (ZBS') oder des berechneten Korrekturfaktors (KF) anpasst.

6. Photovoltaik-Wechselrichter nach Anspruch 5,
wobei die Kalibriereinheit (5) des Photovoltaik-Wechselrichters (1) eine Abweichung zwischen dem durch die Empfangseinheit (4) empfangenen Referenzsignal (RS) und dem von dem Zeitsignalgenerator (3) erhaltenen Zeitbasissignal (ZBS) ermittelt, und das erhaltene Zeitbasissignal (ZBS) zur Minimierung der ermittelten Abweichung automatisch fortlaufend oder in regelmäßigen Zeitabständen korrigiert.

7. Photovoltaik-Wechselrichter nach Anspruch 6,
wobei die durch die Kalibriereinheit (5) ermittelten Abweichungen zwischen dem von der Empfangseinheit (4) empfangenen Referenzsignal (RS) und dem von dem Zeitsignalgenerator (3) erhaltenen Zeitbasissignal (ZBS) oder der durch die Kalibriereinheit (5) berechnete Korrekturfaktor (KF) in den Datenspeicher (7) des Photovoltaik-Wechselrichters (1) gespeichert werden.

8. Photovoltaik-Wechselrichter nach Anspruch 7,
wobei die ermittelten Abweichungen zwischen dem von der Empfangseinheit (4) empfangenen Referenzsignal (RS) und dem von dem Zeitsignalgenerator (3) erhaltenen Zeitbasissignal (ZBS) und/oder der berechnete Korrekturfaktor (KF) zusammen mit dem mindestens einen Betriebsparameter (BP) des Photovoltaik-Wechselrichters (1) in dem Datenspeicher (7) des Photovoltaik-Wechselrichters (1) gespeichert werden.

9. Photovoltaik-Wechselrichter nach einem der vorangehenden Ansprüche 5 bis 8,
wobei eine Messeinheit des Photovoltaik-Wechselrichters (1) eine aktuelle Netzfrequenz eines Stromversorgungsnetzwerkes (SVN) auf Grundlage des von der Kalibriereinheit (5) korrigierten Zeitbasissignales (ZBS') ermittelt.

10. Photovoltaik-Wechselrichter nach einem der vorangehenden Ansprüche 5 bis 9,
wobei der Zeitsignalgenerator (3) einen Quarz, Resonator oder Oszillator aufweist, der ein oszillierendes Zeitbasissignal (ZBS) erzeugt und an die Kalibriereinheit (5) des Photovoltaik-Wechselrichters (1) überträgt.

11. Photovoltaik-Wechselrichter nach einem der vorangehenden Ansprüche 5 bis 10,
wobei die Empfangseinheit (4) des Photovoltaik-Wechselrichters (1) einen Radiosignalempfänger aufweist, der ein Radio-Referenzsignal von einer Radiosignalquelle empfängt, oder
wobei die Empfangseinheit (4) des Photovoltaik-Wechselrichters (1) einen GPS-Empfänger aufweist, der ein GPS-Referenzsignal von einer GPS-Signalquelle empfängt, oder
wobei die Empfangseinheit (4) des Photovoltaik-Wechselrichters (1) über ein Datennetzwerk ein Referenzsignal (RS) von einem Server empfängt.

12. Photovoltaik-Wechselrichter nach einem der vorangehenden Ansprüche, wobei Vorgabewerte (SOLL) von elektrischen Strömen, I, oder von elektrischer Leistung, P, zur Ansteuerung von zumindest einer elektronischen Komponente oder Stufe der Umwandlungsschaltung (2) durch die Steuereinheit (6) des Photovoltaik-Wechselrichters (1) auf Basis des durch die Kalibriereinheit (5) korrigierten Zeitbasissignals (ZBS') oder auf Basis des durch die Kalibriereinheit (5) berechneten Korrekturfaktors (KF) fortlaufend angepasst werden.

13. Photovoltaik-Anlage mit einem Photovoltaikfeld zur Erzeugung einen DC-Gleichstrom, der durch einen Photovoltaik-Wechselrichter (1) nach einem der vorangehenden Ansprüche 5 bis 12 in einen AC-Wechselstrom für ein Stromversorgungsnetzwerk (SVN) und/oder für lokale Stromverbraucher umgewandelt wird.

## Claims

1. A method for calibrating a time base signal (ZBS) in a photovoltaic inverter (1), which comprises a conversion circuit (2) with components for converting a DC current into an AC current, comprising the following steps:
- receiving (S-A) a reference signal (RS) by a receiving unit (4) of the photovoltaic inverter (1) from an external reference signal source (RSQ);
- determining (S-B) a deviation between the received reference signal (RS) and a time base signal (ZBS) generated by a local time signal generator (3) of the photovoltaic inverter (1), wherein the time base signal (ZBS) is formed by a clock signal;
- correcting (S-C) the time base signal (ZBS) to minimize the deviation or calculating a correction factor (KF),
wherein the time base signal (ZBS) generated by the time signal generator (3) is automatically corrected based on the reference signal (RS) when the reference signal (RS) is available, and
wherein the time base signal (ZBS) generated by the time signal generator (3) is automatically corrected, when the reference signal (RS) is temporarily unavailable, based on at least one stored operating parameter (BP), which is determined by a measured internal temperature prevailing within the housing of the photovoltaic inverter (1) and/or by a measured supply voltage; and
- adjusting (S-D) setpoints (SOLL) for at least one component of the conversion circuit (2) based on the corrected time base signal (ZBS') or based on a function of the calculated correction factor (KF).

2. The method according to claim 1,
wherein the time base signal (ZBS) to minimize the determined deviation is automatically corrected continuously or at regular time intervals.

3. The method according to claim 1 or 2,
wherein the determined deviations between the reference signal (RS) received by the receiving unit (4) and the time base signal (ZBS) generated by the time signal generator (3) and/or the calculated correction factor (KF) together with at least the operating parameter (BP) of the photovoltaic inverter (1) are stored in a data memory (7) of a calibration unit (5) of the photovoltaic inverter (1).

4. The method according to claim 3,
wherein the internal temperature prevailing within the housing of the photovoltaic inverter (1) is measured by a temperature sensor (9) of the photovoltaic inverter (1).

5. A photovoltaic inverter (1) comprising:
- a conversion circuit (2) comprising electronic components that convert an obtained DC current into an AC current;
- a time signal generator (3) that generates a time base signal (ZBS) comprising a clock signal;
- a receiving unit (4) designed to receive a reference signal (RS) from an external reference signal source (RSQ);
- a calibration unit (5) that receives the time base signal (ZBS) from the time signal generator (3) and automatically corrects the time base signal (ZBS) based on the reference signal (RS) received by the receiving unit (4), or calculates a correction factor (KF),
wherein the calibration unit (5) is configured to:
• automatically correct the time base signal (ZBS) generated by the time signal generator (3) based on the reference signal (RS) when the reference signal (RS) is available, and
• when the reference signal (RS) is temporarily unavailable, to automatically correct the time base signal (ZBS) generated by the time signal generator (3) based on at least one operating parameter (BP) stored in a data memory (7) of the photovoltaic inverter (1), which operating parameter is formed by an internal temperature prevailing within the housing of the photovoltaic inverter (1), and/or a measured supply voltage; and
- a control unit (6) that adjusts one or more setpoints (SOLL) for a regulating unit (2D) of the conversion circuit (2) of the photovoltaic inverter (1) based on the corrected time base signal (ZBS') or the calculated correction factor (KF).

6. The photovoltaic inverter according to claim 5,
wherein the calibration unit (5) of the photovoltaic inverter (1) determines a deviation between the reference signal (RS) received by the receiving unit (4) and the time base signal (ZBS) obtained from the time signal generator (3), and automatically corrects the received time base signal (ZBS) continuously or at regular intervals to minimize the determined deviation.

7. The photovoltaic inverter according to claim 6,
wherein the deviations determined by the calibration unit (5) between the reference signal (RS) received by the receiving unit (4) and the time base signal (ZBS) obtained from the time signal generator (3), or the correction factor (KF) calculated by the calibration unit (5) are stored in the data memory (7) of the photovoltaic inverter (1).

8. The photovoltaic inverter according to claim 7,
wherein the determined deviations between the reference signal (RS) received by the receiving unit (4) and the time base signal (ZBS) obtained from the time signal generator (3) and/or the calculated correction factor (KF) together with the at least one operating parameter (BP) of the photovoltaic inverter (1) are stored in the data memory (7) of the photovoltaic inverter (1).

9. The photovoltaic inverter according to any one of the preceding claims 5 to 8,
wherein a measuring unit of the photovoltaic inverter (1) determines the current grid frequency of a power supply network (SVN) based on the time base signal (ZBS') corrected by the calibration unit (5).

10. The photovoltaic inverter according to any one of claims 5 to 9,
wherein the time signal generator (3) comprises a quartz crystal, resonator, or oscillator that generates an oscillating time base signal (ZBS) and transmits it to the calibration unit (5) of the photovoltaic inverter (1).

11. The photovoltaic inverter according to any one of the preceding claims 5 to 10,
wherein the receiving unit (4) of the photovoltaic inverter (1) comprises a radio signal receiver that receives a radio reference signal from a radio signal source, or
wherein the receiving unit (4) of the photovoltaic inverter (1) comprises a GPS receiver that receives a GPS reference signal from a GPS signal source, or
wherein the receiving unit (4) of the photovoltaic inverter (1) receives a reference signal (RS) from a server via a data network.

12. The photovoltaic inverter according to any one of the preceding claims, wherein setpoints (SOLL) of electrical currents, I, or of electrical power, P, for controlling at least one electronic component or stage of the conversion circuit (2) are continuously adjusted by the control unit (6) of the photovoltaic inverter (1) based on the time base signal (ZBS') corrected by the calibration unit (5) or based on the correction factor (KF) calculated by the calibration unit (5).

13. Photovoltaic system comprising a photovoltaic array for generating a DC current, which is converted by a photovoltaic inverter (1) according to one of the preceding claims 5 to 12 into an AC current for a power supply network (SVN) and/or for local power consumers.

## Revendications

1. Procédé d'étalonnage d'un signal de base de temps (ZBS) dans un onduleur photovoltaïque (1) qui présente un circuit de conversion (2) avec des composants destinés à convertir un courant continu DC en un courant alternatif AC, comportant les étapes suivantes consistant à :
- recevoir (S-A), par une unité de réception (4) de l'onduleur photovoltaïque (1), un signal de référence (RS) provenant d'une source de signal de référence (RSQ) externe ;
- déterminer (S-B) un écart entre le signal de référence (RS) reçu et un signal de base de temps (ZBS) qui est généré par un générateur local de signal temporel (3) de l'onduleur photovoltaïque (1), dans lequel le signal de base de temps (ZBS) est formé par un signal d'horloge ;
- corriger (S-C) le signal de base de temps (ZBS) pour minimiser l'écart ou calculer un facteur de correction (KF) ;
dans lequel le signal de base de temps (ZBS) généré par le générateur de signal temporel (3) lorsque le signal de référence (RS) est disponible est corrigé automatiquement en fonction du signal de référence (RS), et
dans lequel le signal de référence (RS) généré par le générateur de signal temporel (3) lorsque le signal de référence (RS) est temporairement indisponible est corrigé automatiquement en fonction d'au moins un paramètre de fonctionnement (BP) stocké, lequel paramètre est formé par une température interne mesurée régnant à l'intérieur du boîtier de l'onduleur photovoltaïque (1) et/ou par une tension d'alimentation mesurée ; et
- ajuster (S-D) des valeurs de consigne (SOLL) pour au moins un composant du circuit de conversion (2) en fonction du signal de base de temps (ZBS') corrigé ou en fonction du facteur de correction (KF) calculé.

2. Procédé selon la revendication 1,
dans lequel le signal de base de temps (ZBS) est corrigé automatiquement en continu ou à des intervalles de temps réguliers afin de minimiser l'écart déterminé.

3. Procédé selon la revendication 1 ou 2,
dans lequel les écarts déterminés entre le signal de référence (RS) reçu par l'unité de réception (4) et le signal de base de temps (ZBS) généré par le générateur de signal temporel (3) et/ou le facteur de correction calculé (KF) sont stockés conjointement avec au moins ledit paramètre de fonctionnement (BP) de l'onduleur photovoltaïque (1) dans une mémoire de données (7) d'une unité d'étalonnage (5) de l'onduleur photovoltaïque (1).

4. Procédé selon la revendication 3,
dans lequel la température interne régnant à l'intérieur du boîtier de l'onduleur photovoltaïque (1) est mesurée par un capteur de température (9) de l'onduleur photovoltaïque (1).

5. Onduleur photovoltaïque (1) comportant :
- un circuit de conversion (2) qui présente des composants électroniques qui convertissent un courant continu DC obtenu en un courant alternatif AC ;
- un générateur de signal temporel (3) qui génère un signal de base de temps (ZBS) présentant un signal d'horloge ;
- une unité de réception (4) qui est destinée à recevoir un signal de référence (RS) provenant d'une source de signal de référence (RSQ) externe ;
- une unité d'étalonnage (5) qui obtient le signal de base de temps (ZBS) du générateur de signal temporel (3) et corrige automatiquement le signal de base de temps (ZBS) sur la base du signal de référence (RS) reçu de l'unité de réception (4) ou calcule un facteur de correction (KF) ;
dans lequel l'unité d'étalonnage (5) est configurée pour corriger automatiquement le signal de base de temps (ZBS) généré par le générateur de signal temporel (3) :
• lorsque le signal de référence (RS) est disponible, en fonction du signal de référence (RS), et
• lorsque le signal de référence (RS) est temporairement indisponible, en fonction d'au moins un paramètre de fonctionnement (BP) stocké dans une mémoire de données (7) de l'onduleur photovoltaïque (1), qui est formé par une température interne régnant à l'intérieur du boîtier de l'onduleur photovoltaïque (1) et/ou par une tension d'alimentation mesurée ; et comporte
- une unité de commande (6) qui ajuste une ou plusieurs valeurs de consigne (SOLL) pour une unité de régulation (2D) du circuit de conversion (2) de l'onduleur photovoltaïque (1) en fonction du signal de base de temps (ZBS') corrigé ou du facteur de correction (KF) calculé.

6. Onduleur photovoltaïque selon la revendication 5,
dans lequel l'unité d'étalonnage (5) de l'onduleur photovoltaïque (1) détermine un écart entre le signal de référence (RS) reçu par l'unité de réception (4) et le signal de base de temps (ZBS) obtenu par le générateur de signal temporel (3), et corrige automatiquement en continu ou à des intervalles de temps réguliers le signal de base de temps (ZBS) obtenu afin de minimiser l'écart déterminé.

7. Onduleur photovoltaïque selon la revendication 6,
dans lequel les écarts déterminés par l'unité d'étalonnage (5) entre le signal de référence (RS) reçu par l'unité de réception (4) et le signal de base de temps (ZBS) obtenu par le générateur de signal temporel (3) ou le facteur de correction (KF) calculé par l'unité d'étalonnage (5) sont stockés dans la mémoire de données (7) de l'onduleur photovoltaïque (1).

8. Onduleur photovoltaïque selon la revendication 7,
dans lequel les écarts déterminés entre le signal de référence (RS) reçu par l'unité de réception (4) et le signal de base de temps (ZBS) obtenu par le générateur de signal temporel (3) et/ou le facteur de correction (KF) calculé sont stockés conjointement avec au moins ledit paramètre de fonctionnement (BP) de l'onduleur photovoltaïque (1) dans la mémoire de données (7) de l'onduleur photovoltaïque (1).

9. Onduleur photovoltaïque selon l'une des revendications 5 à 8 précédentes,
dans lequel une unité de mesure de l'onduleur photovoltaïque (1) détermine une fréquence de réseau actuelle d'un réseau d'alimentation électrique (SVN) sur la base du signal de base de temps (ZBS') corrigé par l'unité d'étalonnage (5).

10. Onduleur photovoltaïque selon l'une des revendications 5 à 9 précédentes,
dans lequel le générateur de signal temporel (3) présente un quartz, un résonateur ou un oscillateur qui génère un signal de base de temps oscillant (ZBS) et le transmet à l'unité d'étalonnage (5) de l'onduleur photovoltaïque (1).

11. Onduleur photovoltaïque selon l'une des revendications 5 à 10 précédentes,
dans lequel l'unité de réception (4) de l'onduleur photovoltaïque (1) présente un récepteur de signal radio qui reçoit un signal de référence radio provenant d'une source de signal radio, ou
dans lequel l'unité de réception (4) de l'onduleur photovoltaïque (1) présente un récepteur GPS qui reçoit un signal de référence GPS provenant d'une source de signal GPS, ou dans lequel l'unité de réception (4) de l'onduleur photovoltaïque (1) reçoit un signal de référence (RS) provenant d'un serveur via un réseau de données.

12. Onduleur photovoltaïque selon l'une des revendications précédentes, dans lequel des valeurs de consigne (SOLL) de courants électriques, I, ou de puissance électrique, P, sont ajustées en continu pour commander au moins un composant électronique ou un étage du circuit de conversion (2) par l'unité de commande (6) de l'onduleur photovoltaïque (1) sur la base du signal de base de temps (ZBS') corrigé par l'unité d'étalonnage (5) ou sur la base du facteur de correction (KF) calculé par l'unité d'étalonnage (5).

13. Centrale photovoltaïque comportant un champ photovoltaïque pour générer un courant continu DC qui est converti par un onduleur photovoltaïque (1) selon l'une des revendications 5 à 12 précédentes en un courant alternatif AC pour un réseau d'alimentation électrique (SVN) et/ou pour des consommateurs électriques locaux.
